Europäisches Patentamt

European Patent Office

Office européen des brevets

(11) Publication number: **0 298 581**
**A2**

## (12) EUROPEAN PATENT APPLICATION

(21) Application number: 88300996.1

(22) Date of filing: 05.02.88

(51) Int. Cl.⁴: **H04L 7/02** , **H03L 7/08**

(30) Priority: 06.07.87 US 70264

(43) Date of publication of application:
**11.01.89 Bulletin  89/02**

(84) Designated Contracting States:
**DE FR GB**

(71) Applicant: **MAGNETIC PERIPHERALS INC.**
**8100-34th Avenue South**
**Minneapolis Minnesota 55440(US)**

(72) Inventor: **Minuhin, Vadim Boris**
**8709 Lakeview Circle**
**Bloomington Minnesota 55438(US)**

(74) Representative: **Caro, William Egerton et al**
**J. MILLER & CO. Lincoln House 296-302 High**
**Holborn**
**London WC1V 7JH(GB)**

(54) **Phase comparator insensitive to clock asymmetry.**

(57) A phase comparator generates a reference pulse signal equal in duration to one bit cell, and a variable pulse having a duration representative of the duration and time displacement of the leading edge of a data pulse from the centre of the bit cell. The phase comparator includes the two D-type flip-flops (Q1,Q2) arranged so that the variable pulse is initiated by the leading edge of the data pulse in the one bit cell, the reference pulse is initiated by the edge of the clock pulse at the end of the one bit cell, and both pulses are terminated by the edge of the clock pulse at the end of the next bit cell. Hence, only clock edges at the bounds of the bit cell affect the pulse durations and the comparator is insensitive to clock asymmetry. A charge pump associated with the phase comparator provides a pump down signal amplitude equal to 3/2 the pump up signal amplitude to correct the relationship that the variable pulse (which generates the pump up signal) is 3/2 the duration of the reference pulse (which generates the pump down signal) where the data pulse edge is nominally in the centre of the bit cell.

FIG. 4

# PHASE COMPARATOR INSENSITIVE TO CLOCK ASYMMETRY

This invention relates to phase comparators insensitive to clock assymetry.

Phase locked loops used in self-synchronising digital recording systems typically include a data-phase comparator, a charge pump, a loop filter, and a voltage controlled oscillator (VCO). The VCO provides a clock signal for data processing purposes. Additionally, the VCO provides a clock feedback to the data phase comparator. The clock signal is used to detect the phase relationship between encoded data (the encoded binary 1s) and the edges of the clock signal. Any phase error between the data stream and the clock signal drives the charge pump which, together with a loop filter, provides a DC signal to the VCO to adjust the phase and frequency thereof. Ideally, the leading edge of a data pulse is at the centre of a bit cell (detection window). However, because the data pulse may actually lead or lag the ideal or nominal condition, the detection window should be as large as possible, occupying as much of the bit cell as possible, so as to recover data located at any arbitrary position with the detection window.

US-A-3,986,125 discloses a data-phase comparator useful with MFM (1,3) codes. However, the logic circuit of US-A-3,986,125 propagates unequal propagation delays resulting in detection windows which are less than the full width of the bit cell, especially at high frequencies (i.e. of the order of 100 MHz). US-A-4,568,881 overcomes many of the disadvantages of US-A-3,986,125 by eliminating the effects of cumulative gate propagation and set up delays through the various components of the data-phase comparator. As a result, US-A-4,568,881 achieves a detection window equal to 100 percent of the bit cell, even at high frequencies (100 MHz). However, US-A-4,568,881 requires a long cycle of operation and therefore can only operate if the encoded data stream has at least two 0s between each encoded 1 (2,7 code). Therefore, it will not operate with a (1,7) or (1,3) code.

Additionally, most prior data-phase comparators, including those of US-A-3,986,125 and US-A-4,568,881, operate on both the leading and trailing edges of clock pulses. As a result, the prior comparators require a perfectly symmetrical clock waveform, as asymmetry in the clock waveform increases error rate in the system. Achieving symmetrical clock waveforms is not an easy task, particularly at high frequencies (100 MHz), as the usual solution is to run the VCO at double frequency and divide the frequency by two, hopefully creating a symmetrical clock. However, additional problems arise in attempts to maintain the VCO at such high frequencies.

The present invention seeks to provide a phase comparator which is insensitive to clock asymmetry, which has a detection window equal to 100 percent of the bit cell even at high frequencies and which is capable of detecting encoded data having only at least one encoded 0 between the encoded 1s (e.g. (1,7) and (1,3) codes).

According to one aspect of the present invention there is provided a phase comparator responsive to a stream of input pulses and a clock pulse stream, said clock pulse stream having a succession of clock pulse leading edges defining the bounds of successive bit cells, said phase comparator, in operation, producing in response to the leading edge of each pulse of said input pulse stream a reference pulse having a duration equal to one bit cell and a variable pulse having a duration which is representative of the direction and time displacement of the leading edge of the input pulse from the centre of the bit cell in which the input pulse occurs, said phase comparator comprising: means responsive to the edge of an input pulse occurring in one bit cell for initiating a variable pulse; means responsive to the edge of a clock pulse occurring at the end of said one bit cell for initiating a reference pulse; and means responsive to the edge of a clock pulse occurring at the end of the next bit cell following said one bit cell for terminating said variable pulse and said reference pulse.

Preferably said means responsive to the edge of an input pulse comprises a first bistable means which, in operation, switches from a first state to a second state in response to the edge of said input pulse to initiate said variable pulse.

In a preferred embodiment said means responsive to the edge of a clock pulse occurring at the end of said one bit cell comprises a second bistable means which, in operation, switches from a first state to a second state in response to the edge of a clock pulse and the end of said one bit cell to maintain said variable pulse and initiate said reference pulse and reset said first bistable means.

Preferably said means responsive to the edge of a clock pulse occurring at the end of said one bit cell comprises a second bistable means which, in operation, switches from its second state to its first state in response to the edge of a clock pulse following reset of said first bistable means to terminate said variable pulse and said reference pulse.

According to another aspect of the present invention there is provided a phase comparator responsive to a stream of input pulses and a clock pulse signal, said clock pulse signal having a succession of clock pulse leading edges defining the ends of successive bit cells, said phase comparator, in operation, producing in response to the edge of each input pulse a reference pulse having a duration equal to one bit cell and a variable pulse having a duration which is representative of the direction and time displacement of the leading edge of the input pulse from the centre of the bit cell in which the input pulse occurs, said phase comparator characterised by comprising: first D-type flip-flop means having a clock input connected to receive said pulse string, a D-input connected to a source, a reset input, a Q-output and a $\overline{Q}$-output; second D-type flip-flop means having a clock input connected to receive said clock pulse signal, a D-input connected to receive a signal from the $\overline{Q}$-output of said first flip-flop means, a Q-output and a $\overline{Q}$-output connected to the reset input of said first flip-flop means, an output of said second flip-flop means, in operation, providing said reference pulse; and OR gate means connected to the Q-outputs of said first and second flip-flop means for providing said variable pulse.

The phase comparator may include charge pump means responsive to said variable pulse and to said reference pulse for supplying an output signal to an output, said charge pump means including a first source for producing a first signal amplitude and a second source for producing a second signal amplitude, said second signal amplitude being greater than said first signal amplitude, first switch means connected to said first source and responsive to said variable pulse for connecting said first signal amplitude to said output, and second switch means connected to said second source and responsive to said reference pulse for connecting said second signal amplitude to said output.

Said second signal amplitude may be 3/2 the value of said first signal amplitude.

The invention is illustrated, merely by way of example, in the accompanying drawings, in which:-

Figure 1 depicts waveforms employed in the dataphase comparator of US-A-4,568,881;

Figure 2 is a block circuit diagram of a typical data-phase comparator, including a phase comparator according to the present invention;

Figure 3 depicts waveforms useful in explaining and distinguishing the operation of a phase comparator according to the present invention from that of the prior art;

Figure 4 is a block circuit diagram of a phase comparator according to the present invention; and

Figures 5A-5C depict various waveforms useful in explaining the operation of the phase comparator of Figure 4.

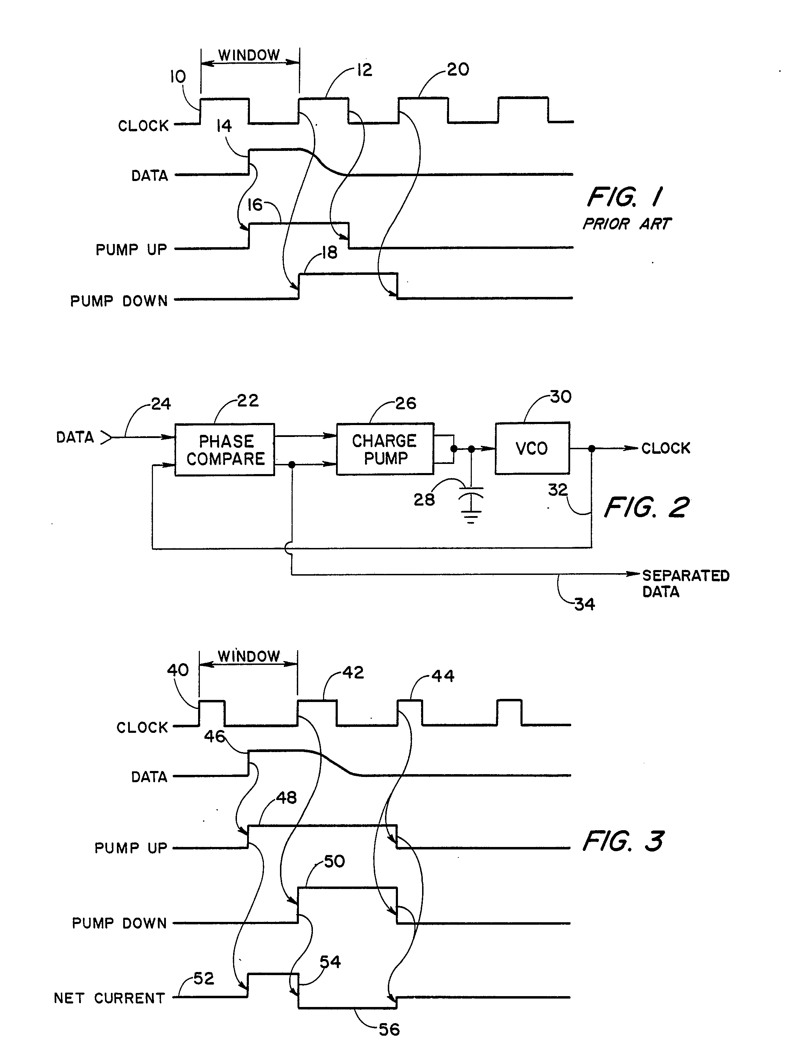

Referring to Figure 1, there is illustrated a series of waveforms illustrating the operation of the phase comparator described in US-A-4,568,881. As shown, a detection window is equal to the entire bit cell between the leading edges of successive clock pulses 10,12, successive clock pulses 12,20, etc. Nominally, the leading edge of a data pulse 14 is centred in the bit cell and detection window, the leading edge of the data pulse 14 establishing the leading edge of a pump up pulse 16. The successive clock pulses are symmetrical so that the trailing edge of the clock pulse 12 establishes the trailing edge of the variable pump up pulse 16. A reference pump down signal 18 is established by the leading edge of the successive clock pulses 12,20. Nominally, the leading edge of the data pulse 14 is at the centre of the detection window (coincident with the trailing edge of the clock pulse 10) so that the duration of the pump up signal 16 is, at nominal conditions, equal to the duration of the pump down signal 18. As the position of the data pulse 14 varies within the detection window established by the clock signal, the length of the pump up pulse 16 will vary to a greater or lesser duration, depending upon the degree and direction of leading and lagging.

Figure 2 illustrates a block diagram of a typical data phase comparator including a phase comparator according to the present invention wherein a phase comparator 22 receives data via an input 24 and provides pump up and pump down signals to a charge pump 26. The charge pump 26 provides a voltage to a filter 28 to operate a voltage controlled oscillator (VCO) 30. The VCO 30 provides a clock signal on an output 32 as well as a feedback to the phase comparator 22. Separated data is taken via an output 34.

In operation of a comparator according to the present invention as illustrated in Figure 3, detection windows are established between the leading edges of successive clock pulses 40,42,44, and therefore encompass entire bit cells. However, unlike prior comparators, the successive clock pulses need not have duty cycles equal to 50 percent of the bit cell, and need not be equal in duration. Thus, as shown, the clock pulses are asymmetrical. Nominally, a data pulse 46 will have its leading edge centred in the detection window established by leading edges of successive clock pulses. Like the comparators of US-A-3,986,125 and US-A-4,568,881, a variable pump up pulse 48 has its leading edge established by the edge of the data pulse 46. Unlike US-A-3,986,125, the leading and trailing edges of a reference pump down pulse 50 are established by the leading edges of successive clock pulses 42,44. Unlike US-A-4,568,881, the trailing edge of the variable pump up pulse 48 is also established by the leading edge of the clock pulse 44.

It can be seen by inspection of the duration of the pump up pulse 48 and the pump down pulse 50 in Figure 3 that nominally the pump up pulse is 1.5 times the duration of the pump down pulse. Therefore, in accordance with the present invention, the charge pump 26 provides a negative pump down current which is 1.5 times the positive pump up current. Therefore, the net current to the filter 28 and the VCO 30 for nominal conditions is illustrated by a waveform 52 and includes a pulse 54 having a positive current I for one-half bit cell followed by a negative pulse 56 having a negative current of one-half I for a full cell. The net electric charge, therefore, is zero.

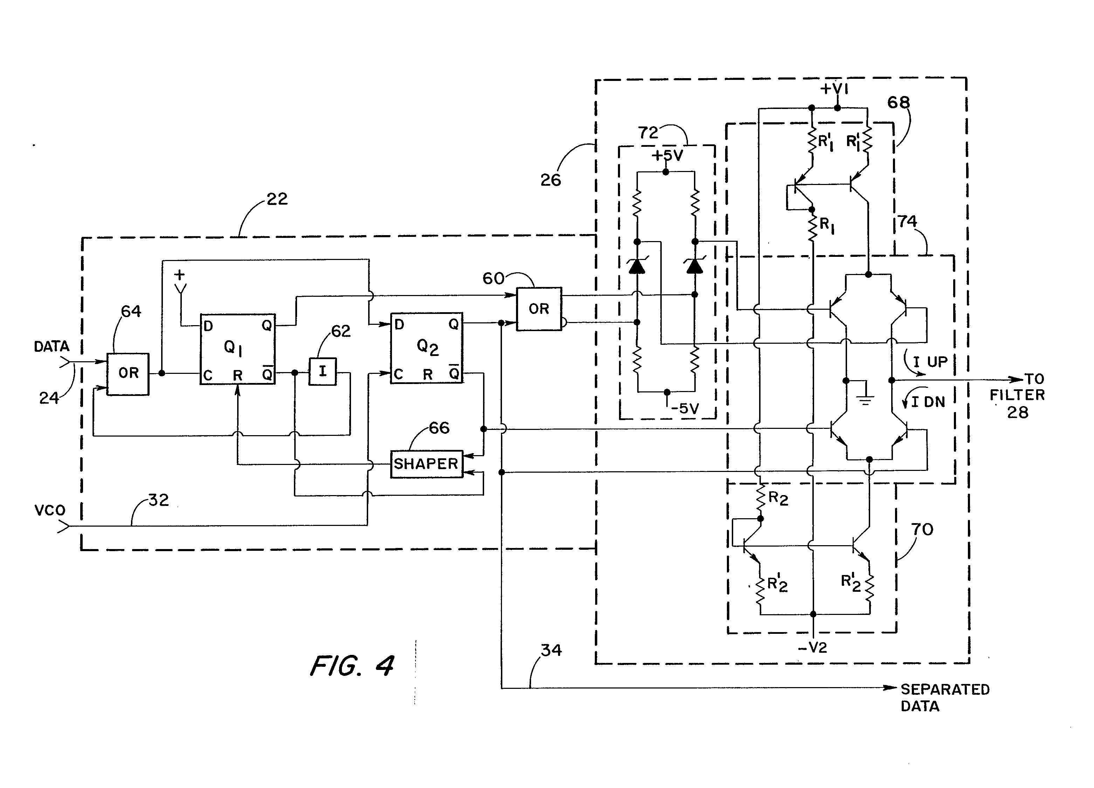

Figure 4 is a block circuit diagram of a phase comparator 22 according to the present invention and the charge pump 26 shown in Figure 2. The comparator 22 comprises a first D-type flip-flop Q1 and a second D-type flip-flop Q2. The D-input of the flip-flop Q1 is connected to a source of high signal, whereas the clock input of the flip-flop Q1 and the D-input of the flip-flop Q2 are connected through an OR gate 64 to the input 24 to receive data signals (i.e. the data pulses 46 in Figure 3). The Q-output of the flip-flop Q1 is provided as one input to an OR gate 60, whereas the $\overline{Q}$ (Q-not) output of the flip-flop Q1 is provided through an inverter 62 to the second input of the OR gate 64. The clock input of the flip-flop Q2 is connected to the output of the VCO 30 via the output 32. The Q-output of the flip-flop Q2 is connected as a second input to the OR gate 60, and the $\overline{Q}$ output of the flip-flops Q1,Q2 are provided to a pulse shaper 66 and thence to the overriding reset input R of the flip-flop Q1.

The charge pump 26 includes a source 68 of positive current and a source 70 of negative current. The source 68 comprises a pair of complementary PNP transistors each connected through a resistor R1$'$ to a positive source (+V1) of voltage (such as +15 volts), and through a resistor R1 to a negative source (-V2) of voltage (such as -15 volts). The source 70 comprises a pair of NPN transistors connected to the negative source through resistors R2$'$ and through a resistor R2 to the positive source. The relationship of the resistors is such that (R1 + R1$'$) equals 3/2 (R2 + R2$'$). Due to this relationship, amplitudes of the pump up current from the source 68 and the pump down current from the source 70 are the inverse of the relationship of the resistors: Iup equals 2/3 Idown.

Complementary logic signals from the OR gate 60 are provided to a level shifter 72 to translate standard emitter-coupled logic levels from the OR gate 60 to the levels necessary for operation of one transistor pair of a switch 74. The switch 74 includes a pair of PNP transistors receiving complementary logic signals from the level shifter 72 and includes a second pair of NPN transistors connected to receive complementary logic signals from the Q- and $\overline{Q}$ -outputs of the flip-flop Q2. The switch 74 operates to pass the Iup and Idown currents for the duration of the pump up and pump down pulses provided by the OR gate 60 and the flip-flop Q2.

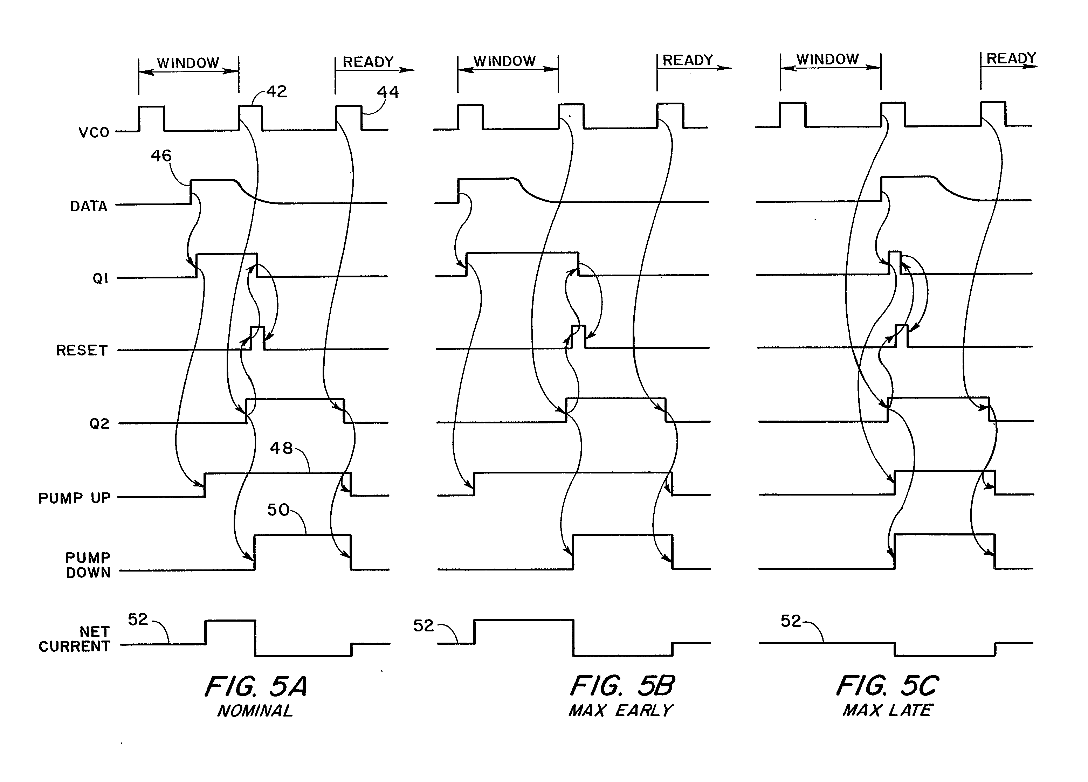

With reference particularly to Figures 4 and 5, the operation of the phase comparator will be explained. At the beginning of each operational cycle, the flip-flop Q1 is in its low state so that the $\overline{Q}$ -output is high and the inverter 62 provides a low input to the OR gate 64. Hence, the OR gate 64 is ready to respond to a data pulse. Referring first to Figures 4 and 5A, a data pulse having a leading edge 46 arrives through the OR gate 64 at the clock input of the flip-flop Q1 and at the D-input of the flip-flop Q2. Since the D-input is always high, the flip-flop Q1 sets its Q-output high to provide an input to the OR gate 60. As the Q-output of the flip-flop Q1 goes high, the OR gate 60 is operated to set the pump up pulse 48 high. Also as the Q-output of the flip-flop Q1 goes high, the $\overline{Q}$ -output thereof goes low, which is inverted by the inverter 62 to drive the OR gate 64 to maintain the D-input of the flip-flop Q2 high. Upon receipt of the leading edge of the next clock pulse 42 at the clock input of the flip-flop Q2, the Q-output of the flip-flop Q2 goes high. The high Q-output of the flip-flop Q2 operates through the OR gate 60 to maintain the pump up pulse 48 high, and sets the pump down pulse 50 high. At the same time, the $\overline{Q}$ -output of the flip-flop Q2 goes low to operate the pulse shaper 66 to reset the flip-flop Q1 to a low condition, thereby clearing the high input of the D-input of the flip-flop Q2. (If the data pulse has not yet gone low, the D-input of the flip-flop Q2 will remain high until it does). Conveniently, the pulse shaper 66 may be a NOR gate operable to supply a reset signal to the flip-flop Q1 when both inputs of the NOR gate are low. Upon reset of the flip-flop Q1, its $\overline{Q}$ -output goes high to provide a high input to the pulse shaper 66 to drive the reset signal low. Upon the next leading edge of the clock pulse 44, the data pulse has gone low thereby removing the high D-input from the flip-flop Q2, and the flip-flop Q2 is set low, thereby driving both the pump up and pump down pulses low. Due to the relationship of the charge pump described above, the pump down pulse amplitude is 3/2 the amplitude of the pump up pulse. The net current is illustrated by waveform 52.

Figure 5A illustrates the waveforms for a nominal condition where the leading edge of the data pulse is in the centre of the detection window. Figure 5B illustrates the waveforms associated where the data pulse is at the beginning of the detection window, whereas Figure 5C illustrates the waveforms where the data pulse is at the end of the detection window. Inspection of the waveforms 52 of each of Figures 5A, 5B and 5C reveals that in the nominal condition the net current is zero, whereas in the early condition the net current is positive and in the late condition the net current is negative. The net current is used to drive the VCO to adjust the clock frequency.

The propagation delay in setting the pump down signal is equal to the propagation delay from the clock input to the Q-output of the flip-flop Q2. The propagation delay to terminate the pump down signal is equal to the propagation delay from the clock input to the Q-output of the flip-flop Q2. The pump down signal will be equal in duration to the clock cycle as measured between the leading edges of successive clock pulses, minus the propagation delay to set.the pump down signal plus the propagation delay to terminate the pump down signal. Since the two propagation delays are equal, their effects are cancelled and the pump down signal will always equal the clock cycle.

The propagation delay in setting the variable pump up signal is equal to the propagation delay from the clock input to the Q-output of the flip-flop Q1, plus the propagation delay through the OR gate 60 and the propagation delay in terminating the pump up signal equals the propagation delay from the clock input to the Q-output of the flip-flop Q2, plus the propagation delay through the OR gate 60. Since the flip-flops are configured on a single chip, the propagation delays for each flip-flop are equal. Hence, the variable pump up signal will be equal in duration to the duration between the leading edge of the data pulse and the leading edge of the successive clock pulse in the bit cell following the bit cell in which the input pulse occurred, minus the propagation delay to set up the pump up signal, plus the propagation delay to terminate the pump up signal. Since the two propagation delays are equal, their effects are cancelled and the duration of the pump up signal will always equal the time between the leading edge of the data pulse and the leading edge of the clock pulse in the bit cell next following that in which the data pulse occurred.

One feature of the present invention resides in the fact that the flip-flop Q1 is reset to its low state by the leading edge of the clock pulse at the end of the bit cell containing the data pulse (by setting the flip-flop Q2 high to drive the pulse shaper 66 to reset the flip-flop Q1). As a result, the phase comparator according to the present invention is ready to respond to data pulses in the bit cell beginning with the leading edge of the next clock pulse following reset of the flip-flop Q1. Consequently, the phase comparator is capable of responding to codes with only one 0 between successive encoded 1s such as (1,3) and (1,7) codes.

Another feature of the phase comparator according to the present invention resides in the fact that the simultaneous appearance of the clock pulse at the clock input of the flip-flop Q1 and the D-input of the flip-flop Q2 permits independent and simultaneous operation of both flip-flops if the data pulse is maximally late at the edge of the clock pulse (Figure 5C). Hence, in the maximum late condition, the flip-flop Q1 is operated by the edge of the data pulse and the flip-flop Q2 is operated by the clock pulse. As a result, the data pulse may appear anywhere in the bit cell, to the leading edges of the clock pulse, thereby ensuring a detection window equal to 100 percent of the bit cell.

The present invention therefor may provide an effective phase comparator capable of achieving the advantages of US-A-4,568,881, yet operating with asymmetric clock pulses and with a greater number of codes.

The design of the phase comparator according to the present invention eliminates the effects of cumulative gate propagation and set up delays through the various components of the phase comparator, thereby maximising the detection window. Moreover, the logic of the phase comparator recovers to establish a detection window in at least alternate bit cells following a bit cell where an encoded 1 is detected. The provision of the charge pump provides different current values to offset the unequal nominal length of the pump up and pump down signals. Furthermore, the phase comparator is responsive solely to a single edge of successive clock signals, such as successive leading edges, so the operation of the phase comparator is independent of clock asymmetry.

## Claims

1. A phase comparator responsive to a stream of input pulses and a clock pulse stream, said clock pulse stream having a succession of clock pulse leading edges defining the bounds of successive bit cells, said phase comparator, in operation, producing in response to the leading edge of each pulse of said input pulse stream a reference pulse having a duration equal to one bit cell and a variable pulse having a duration which is representative of the direction and time displacement of the leading edge of the input pulse from the centre of the bit cell in which the input pulse occurs, said phase comparator comprising: means (Q1) responsive to the edge of an input pulse occurring in one bit cell for initiating a variable pulse; means (Q2) responsive to the edge of a clock pulse occurring at the end of said one bit cell for initiating a reference pulse; and means (Q2) responsive to the edge of a clock pulse occurring at the end of the next bit cell following said one bit cell for terminating said variable pulse and said reference pulse.

2. A phase comparator as claimed in claim 1 characterised in that said means responsive to the edge of an input pulse comprises a first bistable means (Q1) which, in operation, switches from a first state to a second state in response to the edge of said input pulse to initiate said variable pulse.

3. A phase comparator as claimed in claim 2 characterised in that said means responsive to the edge of a clock pulse occurring at the end of said one bit cell comprises a second bistable means (Q2) which, in operation, switches from a first state to a second state in response to the edge of a clock pulse and the end of said one bit cell to maintain said variable pulse and initiate said reference pulse and reset said first bistable means (Q1).

4. A phase comparator as claimed in claim 2 or 3 characterised in that said means responsive to the edge of a clock pulse occurring at the end of said one bit cell comprises a second bistable means (Q2) which, in operation, switches from its second state to its first state in response to the edge of a clock pulse following reset of said first bistable means to terminate said variable pulse and said reference pulse.

5. A phase comparator responsive to a stream of input pulses and a clock pulse signal, said clock pulse signal having a succession of clock pulse leading edges defining the ends of successive bit cells, said phase comparator, in operation, producing in response to the edge of each input pulse a reference pulse having a duration equal to one bit cell and a variable pulse having a duration which is representative of the direction and time displacement of the leading edge of the input pulse from the centre of the bit cell in which the input pulse occurs, said phase comparator characterised by comprising: first D-type flip-flop means (Q1) having a clock input connected to receive said pulse string, a D-input connected to a source, a reset input, a Q-output and a $\overline{Q}$ -output; second D-type flip-flop means (Q2) having a clock input connected to receive said clock pulse signal, a D-input connected to receive a signal from the $\overline{Q}$ -output of said first flip-flop means (Q1), a Q-output and a $\overline{Q}$ -output connected to the reset input of said first flip-flop means, an output of said second flip-flop means, in operation, providing said reference pulse; and OR gate means (60) connected to the Q-outputs of said first and second flip-flop means (Q1,Q2) for providing said variable pulse.

6. A phase comparator as claimed in any preceding claim characterised by including charge pump means (26) responsive to said variable pulse and to said reference pulse for supplying an output signal to an output, said charge pump means including a first source (68) for producing a first signal amplitude and a second source (70) for producing a second signal amplitude, said second signal amplitude being greater than said first signal amplitude, first switch means (74) connected to said first source and responsive to said variable pulse for connecting said first signal amplitude to said output, and second switch means (74) connected to said second source and responsive to said reference pulse for connecting said second signal amplitude to said output.

7. A phase comparator as claimed in claim 6 characterised in that said second signal amplitude is 3/2 the value of said first signal amplitude.

EP 0 298 581 A2

WINDOW

CLOCK

DATA

PUMP UP

PUMP DOWN

*FIG. 1*
*PRIOR ART*

DATA

PHASE COMPARE

CHARGE PUMP

VCO

CLOCK

SEPARATED DATA

*FIG. 2*

WINDOW

CLOCK

DATA

PUMP UP

PUMP DOWN

NET CURRENT

*FIG. 3*

FIG. 4

EP 0 298 581 A2

FIG. 5A
NOMINAL

FIG. 5B
MAX EARLY

FIG. 5C
MAX LATE

EP 0 298 581 A2